Europäisches Patentamt

(19) European Patent Office

Office européen des brevets

(11) **EP 0 828 172 A1**

(12) **EUROPEAN PATENT APPLICATION**

(43) Date of publication:
11.03.1998 Bulletin 1998/11

(51) Int. Cl.⁶: **G02B 13/24**, G03F 7/20

(21) Application number: 97114588.3

(22) Date of filing: 22.08.1997

(84) Designated Contracting States:
AT BE CH DE DK ES FI FR GB GR IE IT LI LU MC
NL PT SE

(30) Priority: 04.09.1996 JP 255505/96

(71) Applicant: NIKON CORPORATION
Tokyo 100 (JP)

(72) Inventors:
• Kudo, Shintaro,
c/o Nikon Corporation
3-chome, Chiyoda-ku, Tokyo 100 (JP)

• Suenaga, Yutaka,
c/o Nikon Corporation
3-chome, Chiyoda-ku, Tokyo 100 (JP)

(74) Representative:
Meddle, Alan Leonard et al
FORRESTER & BOEHMERT
Franz-Joseph-Strasse 38
80801 München (DE)

(54) **Optical projection system and exposure apparatus**

(57)     High-performance projection lens systems are disclosed for use in projection-optical systems as used in, e.g., microlithography for manufacturing semiconductor devices and displays. Each lens system is telecentric on both ends; the entrance and exit pupils are situated substantially at infinity. The lens systems exhibit excellent correction of the Petzval's sum to ensure image-surface evenness in a wide exposure region, favorable correction of all aberrations, and large numerical aperture for high projection resolution. A projection lens comprises, in order from the reticle side, a positive first lens group, a positive second lens group, a negative third lens group, a positive fourth lens group, a negative fifth lens group, and a positive sixth lens group. The projection lenses satisfy a number of quantitative conditions.

FIG. 2

## Description

### Field of the Invention

The present invention pertains to optical projection systems as used in microlithography. More specifically, the invention pertains to optical projection systems for projecting a pattern, defined by a mask or reticle, onto a surface of a sensitized substrate as a part of an overall process for manufacturing semiconductor devices or certain types of display panels (e.g., liquid crystal displays). The pattern defined by the mask essentially functions as a first object and the substrate (e.g., a wafer or plate) functions as a second object.

### Background of the Invention

In recent years, reduction-type projection-exposure systems have been widely used for manufacturing integrated circuits (e.g., ICs and LSIs) and certain types of displays. The increased integration of ICs and LSIs has driven the necessity, in the projection lenses used in such projection-exposure systems, for wider exposure regions and improved resolving power extending over the entire exposure region. Improving resolving power is usually addressed by shortening the exposure wavelength and increasing the numerical aperture (NA) of the projection lens.

To provide shorter exposure wavelengths, attention has been focused on excimer lasers, notably the KrF excimer laser (248 nm) and the ArF excimer laser (193 nm) to replace g-beam (436 nm) and i-beam (365 nm) ultraviolet illumination light produced by conventional high-pressure mercury lamps. Projection lenses have been proposed for use with each of these exposure wavelengths.

To achieve a wide exposure region per exposure, the Petzval's sum of the projection lens must be reduced sufficiently to correct any image-surface curvature caused by the projection lens. Due to limitations on the overall size of an actual projection-exposure apparatus, the length (distance between the first and second object) of the projection lens is usually limited. Within such constraints, it is necessary to simultaneously correct the Petzval's sum and coma aberrations, as well as other aberrations, over the entire wide exposure region. Such corrections are very difficult to achieve when the numerical aperture (NA) of the lens must be increased to improve resolving power.

It is also important to reduce image distortions (distortion aberrations) caused by the projection lens as well as projection-magnification errors that become manifest when making overlapping exposures. To reduce projection-magnification errors, the exit pupil is conventionally positioned at infinity (a projection lens having such a property is termed "telecentric on the image side"). This has allowed variations in the projection magnification caused by axial errors in the image surface (such as flatness of the substrate) or focus errors to be largely ignored.

However, with increasing demands being placed on optical performance of the projection lens as feature sizes continue to decrease, it is becoming impossible to ignore such factors as flatness of the mask on the object side. Consequently, projection lenses that are telecentric on both sides (object side and image side) have been proposed. Examples of such lenses are discussed in Japanese *Kokai* (Laid-Open) patent document no. 63-118115 (1988), *Kokai* patent document no. 4-157412 (1992), and *Kokai* patent document no. 5-173065 (1993). Lenses as disclosed in these references, however, have numerical apertures that are too small to contribute favorably to improving resolving power. Also, these lenses do not achieve a satisfactory balance of correcting the Petzval's sum and correcting other aberrations.

### Summary of the Invention

In view of the foregoing, an object of the present invention is to provide "two-sided telecentric" projection-optical systems (projection lenses) in which the entrance pupil and the exit pupil are each essentially at infinity and that exhibit a satisfactory balance of correction of the Petzval's sum (to ensure flatness of the image surface over a wide exposure region) and correction of all aberrations while providing a sufficiently large NA for projection-transferring patterns having sub-micron features at high resolution.

To achieve the foregoing object, projection lenses are provided according to the invention that project an image of a first object (e.g., a pattern on a mask) onto a second object (e.g., a semiconductor wafer or other suitable substrate). According to a preferred embodiment, such a projection lens system comprises, along an optical axis in order from the first-object side: first, second, third, fourth, fifth, and sixth lens groups. The first lens group has a positive power and a focal length $f_1$; the second lens group has a positive power and a focal length $f_2$; the third lens group has a negative power and a focal length $f_3$; the fourth lens group has a positive power and a focal length $f_4$; the fifth lens group has a negative power and a focal length $f_5$; and the sixth lens group has a positive power and a focal length $f_6$. The projection lens system preferably satisfies the following conditional expressions:

$$|E_n| > L$$

$$|E_x| > |L/\beta|$$

$$1.0 < bf_1/f_1 < 1.5$$

$$0.04 < [f_3/L[ < 0.06$$

$$0.04 < [f_5/L| < 0.06$$

$$0.6 < f_6/f_4 < 1.3$$

wherein L is the axial distance from the first object to the second object; $E_n$ is the distance from the axial vertex of a most first-objectwise lens surface of the lens system to the entrance pupil of the lens system; $E_x$ is the distance from the axial vertex of a most second-objectwise lens surface of the lens system to the exit pupil of the lens system; and $bf_1$ is the distance from the axial vertex of a most second-objectwise lens surface of the first lens group to a rear focal point of the first lens group.

The projection lens system as summarized above also preferably satisfies at least one of the following conditional expressions:

$$-0.5 < (\Sigma P_1 + \Sigma P_2)/\Sigma P_3 < -0.2$$

$$0.14 < f_2/L < 0.25$$

$$|\phi \cdot L| < 6.7$$

wherein $\Sigma P_1$ is the Petzval's sum of the first lens group; $\Sigma P_2$ is the Petzval's sum of the second lens group; $\Sigma P_3$ is the Petzval's sum of the third lens group; and $\phi$ is the power of any lens surface in the third lens group and the fifth lens group.

The projection lens system as summarized above also preferably has a power configuration in the first lens group characteristic of a reversed telescopic system.

In addition, projection lenses according to the invention have a projection magnification $\beta$ such that $|\beta| < 1$.

The invention also encompasses projection-exposure apparatus that comprise a projection lens as summarized above. In addition to the projection lens, the projection-exposure apparatus comprises an illumination-optical system for illuminating a reticle defining a pattern. The projection lens system receives illumination light passing through the reticle and projects an image of the reticle pattern onto a substrate. The illumination light is preferably an ultraviolet light.

The foregoing and other features and advantages of the invention will be more readily apparent from the following detailed description, which proceeds with reference to the accompanying drawings.

## Brief Description of the Drawings

FIG. 1 is a schematic elevational view of a preferred embodiment of a projection-exposure apparatus comprising a projection lens according to the present invention.

FIG. 2 is an optical diagram showing the lens composition of Example Embodiment 1.
FIG. 3 is an optical diagram showing the lens composition of Example Embodiment 2.
FIG. 4 is an optical diagram showing the lens composition of Example Embodiment 3.
FIG. 5 is an optical diagram showing the lens composition of Example Embodiment 4.
FIG. 6 is an optical diagram showing the lens composition of Example Embodiment 5.
FIGS. 7(a)-7(d) are aberration plots for Example Embodiment 1.
FIGS. 8(a)-8(d) are aberration plots for Example Embodiment 2.
FIGS. 9(a)-9(d) are aberration plots for Example Embodiment 3.
FIGS. 10(a)-10(d) are aberration plots for Example Embodiment 4.
FIGS. 11(a)-11(d) are aberration plots for Example Embodiment 5.

## Detailed Description

According to a preferred embodiment, projection lenses according to the present invention comprise, in order from the object side, a first lens group $G_1$ having positive power, a second lens group $G_2$ having positive power, a third lens group $G_3$ having negative power, a fourth lens group $G_4$ having positive power, a fifth lens group $G_5$ having negative power, and a sixth lens group $G_6$ having positive power. In addition, a preferred embodiment satisfies the following con-

ditional expressions:

$$|E_n| > L \tag{1}$$

$$|E_x| > |L/\beta| \tag{2}$$

$$1.0 < bf_1/f_1 < 1.5 \tag{3}$$

$$0.04 < |f_3/L| < 0.06 \tag{4}$$

$$0.04 < |f_5/L| < 0.06 \tag{5}$$

$$0.6 < f_6/f_4 < 1.3 \tag{6}$$

wherein L is the axial distance from the "first object" (i.e., mask) to the "second object" (i.e., substrate surface); $E_n$ is the distance, on the first-object side, from the axial vertex of the lens surface (first lens surface) closest to the first object to the entrance pupil; $E_x$ is the distance, on the second-object side, from the axial vertex of the lens surface (last lens surface) closest to the second object to the exit pupil; $\beta$ is the projection magnification of the projection lens; $f_1$ is the focal length of the first lens group; $bf_1$ is the distance, from the axial vertex of the lens surface on the second-object side of the first lens group to the rear focal point (on the second-object side) of the first lens group; $f_3$ is the focal length of the third lens group; $f_4$ is the focal length of the fourth lens group; $f_5$ is the focal length of the fifth lens group; and $f_6$ is the focal length of the sixth lens group.

In projection lenses according to the present invention, image distortion due to deflections in the axial direction (such as a flatness error on the object side or the image side) are inconsequential because the lenses are substantially telecentric on both the object side and the image side. Such telecentricity is ensured by satisfying conditional expressions (1) and (2), above.

Conditional expression (1) stipulates the position of the entrance pupil of the projection lens. The position of the entrance pupil is determined as a distance of an image position, at the paraxial region of the aperture stop (AS), as measured from the axial vertex of the surface of the first lens element on the first-object side. Not satisfying conditional expression (1) would result in a significant distortion of the image surface (on the substrate) caused by, for example, deflection of the first-object (mask) surface.

In a similar manner, conditional expression (2) stipulates the position of the exit pupil. Not satisfying conditional expression (2) would result in a significant distortion of the image surface caused by, for example, axially extending errors such as flatness deviations of the second object (e.g., wafer or other substrate) or by focus errors arising during transfer of the circuit pattern on the mask.

Conditional expression (3) must be satisfied to ensure that the first lens group $G_1$ keeps the first-object side in the telecentric optical system and that the Petzval's sum is sufficiently low. Conditional expression (3) stipulates the power level of the reversed telescopic system of the first lens group $G_1$ in order to favorably correct the Petzval's sum. Exceeding the lower limit of conditional expression (3) would cause the principal point on the rear (imagewise) side of the first lens group $G_1$ to be too close to the first object. Such a situation would make it impossible to configure a negative power suitable to the position close to the first object. This, in turn, would make it difficult to favorably correct the Petzval's sum. Exceeding the upper limit of conditional expression (3) would facilitate correction of the Petzval's sum. However, the negative power close to the first-object point would become relatively too strong thereby making it impossible to favorably correct distortion. Even better results would be obtained by setting the lower limit of conditional expression (3) at 1.03 and the upper limit at 1.40.

As suggested by the foregoing, it is preferred that first lens group $G_1$ be configured as a reversed telescopic system comprising, in order from the object (first-object) side, a negative subgroup and a positive subgroup. By providing such a power configuration, the light flux passing through the projection lens is gently curved thereby making it possible to decrease generation of higher-order aberrations.

The positive second lens group $G_2$ placed immediately after the first lens group $G_1$ mainly corrects distortion. In concrete terms, a positive distortion is generated by the second lens group $G_2$. This positive distortion balances with the negative distortion generated by the concave surfaces of the first lens group $G_1$ and the third lens group $G_3$.

The third lens group $G_3$ and the fifth lens group $G_5$ mainly correct the Petzval's sum of the projection lens. Satisfying conditional expressions (4) and (5) provides a balance of correcting the Petzval's sum with favorably correcting all other aberrations. This, in turn, allows a large numerical aperture (NA) to be obtained.

Exceeding the upper limit of conditional expression (4) would make the negative power of the third lens group $G_3$ too weak, making it impossible to favorably correct the Petzval's sum. Falling below the lower limit of conditional expression (4) would cause the negative power of the third lens group $G_3$ to be too strong, making it impossible to favorably correct coma aberrations and distortion generated by the third lens group $G_3$.

Exceeding the upper limit of conditional expression (5) would make the negative power of the fifth lens group $G_5$ too weak, making it impossible to favorably correct the Petzval's sum. Falling below the lower limit of conditional expression (5) would make the negative power of the fifth lens group $G_5$ too strong. This would make it impossible to favorably correct sagittal coma flare generated by the fifth lens group $G_5$.

The fifth lens group $G_5$ is disposed between the fourth lens group $G_4$ and the sixth lens group $G_6$. The fifth lens group $G_5$ comprises a variation of a double-Gauss lens. A double-Gauss configuration is symmetrical and is thus effective in canceling out aberrations. Such symmetry is maximally exploited in projection lenses according to this invention.

Conditional expression (6) stipulates the ratio of the power of the fourth lens group $G_4$ and the sixth lens group $G_6$ that would be suitable for favorably correcting aberrations. If conditional expression (6) were not satisfied, then adequate cancellation of aberrations using symmetrical characteristics could not be achieved. This would make it impossible to favorably correct coma aberrations or distortion.

It is also preferred that the following conditional expression be satisfied:

$$-0.5 < (\Sigma P_1 + \Sigma P_2)/\Sigma P_3 < -0.2 \tag{7}$$

wherein $\Sigma P_1$ is the Petzval's sum of the first lens group $G_1$; $\Sigma P_2$ is the Petzval's sum of the second lens group $G_2$; and $\Sigma P_3$ is the Petzval's sum of the third lens group $G_3$. Falling below the lower limit of conditional expression (7) would result in an excessive increase in the Petzval's sum caused by the second lens group $G_2$ compared to the first lens group $G_1$ and the third lens group $G_3$. Consequently, an excessive burden would be placed on the negative power of the fifth lens group $G_5$ to offset the effect on the Petzval's sum by the second lens group $G_2$. This, in turn, would make it impossible to correct sagittal coma flare generated by the fifth lens group $G_5$. Exceeding the upper limit of conditional expression (7) would not create a problem with the Petzval's sum, but the effect of the convex surfaces of the second lens group $G_2$ would be too weak compared to the negative distortion generated by the concave surfaces of the first lens group $G_1$ and the third lens group $G_3$. This would result in an insufficient generation of positive distortion by the second lens group $G_2$, which would make it too difficult to favorably correct the negative distortion generated by the first lens group $G_1$ and the third lens group $G_3$.

The contribution $P_i$ to the Petzval's sum of each lens surface of the projection lens is normally defined by the following equation (a):

$$P_i = (\frac{1}{n_{i-1}} - \frac{1}{n_i})\frac{1}{r_i} \tag{a}$$

wherein $r_i$ is the curvature radius and $n_i$ is the refractive index of the medium following the "ith" lens surface. When $r_i$ is infinity (characteristic of a plane), $P_i$ is 0.

It is also preferable that the following conditional expression be satisfied:

$$0.14 < f_2/L < 0.25 \tag{8}$$

wherein $f_2$ is the focal length of the second lens group $G_2$. Exceeding the upper limit of conditional expression (8) would result in the positive power of the second lens group $G_2$ being too weak, thereby making it difficult to favorably correct distortion. Falling below the lower limit of conditional expression (8) would cause the positive power of the second lens group $G_2$ to be too strong. The resulting generation of higher-order distortions would be significant along with a significant (and unacceptable) increase in the Petzval's sum.

It is also preferable for the following conditional expression to be satisfied with respect to the lens elements in the third and fifth lens groups:

$$|\phi \cdot L| < 6.7 \tag{9}$$

wherein $\phi$ is the power of the lens surface of any lens element in the third and fifth lens groups $G_3$, $G_5$. Exceeding the limit of conditional expression (9) would cause the power of any of the subject lens surfaces to be too strong. This would result in the generation of significant higher-order aberrations that would be difficult to correct in the other lens elements and lens groups.

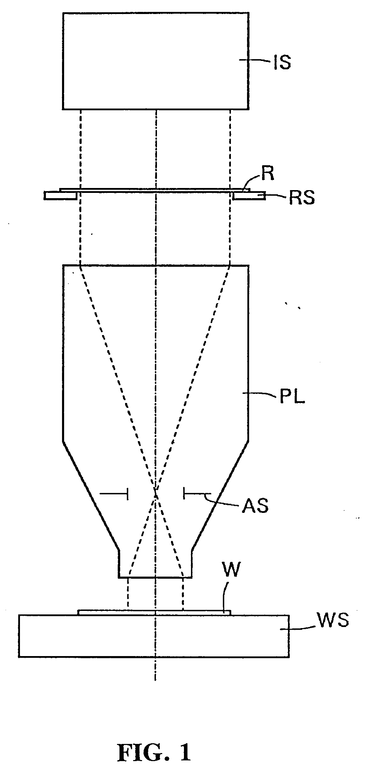

A projection-exposure apparatus according to the invention comprising a projection lens as described generally above is depicted schematically in FIG. 1. A reticle R (serving as the "first object") is disposed on the object side of a projection lens PL. The reticle R defines the pattern to be projected, such as a circuit pattern. A substrate (usually a wafer W) serving as the "second object" is disposed in the image plane of the projection lens PL. The reticle R is held by a reticle stage RS and the wafer W is held by a wafer stage WS.

An illumination-optical system IS is disposed above the reticle R. The illumination-optical system IS uniformly illuminates the reticle R by KÖhler illumination. The light is produced by a light source which is not specifically shown but is understood to be part of the illumination-optical system IS.

The projection lens PL is telecentric at least on the object side. Thus, an image of the light source (inside the illumination-optical system IS) is formed at the aperture stop AS of the projection lens PL. The projection lens PL exposes (transfers) the pattern on the reticle R onto the wafer W.

The light source is most preferably an excimer laser having an exposure wavelength $\lambda$ of 193.4 nm.

## Example Embodiments

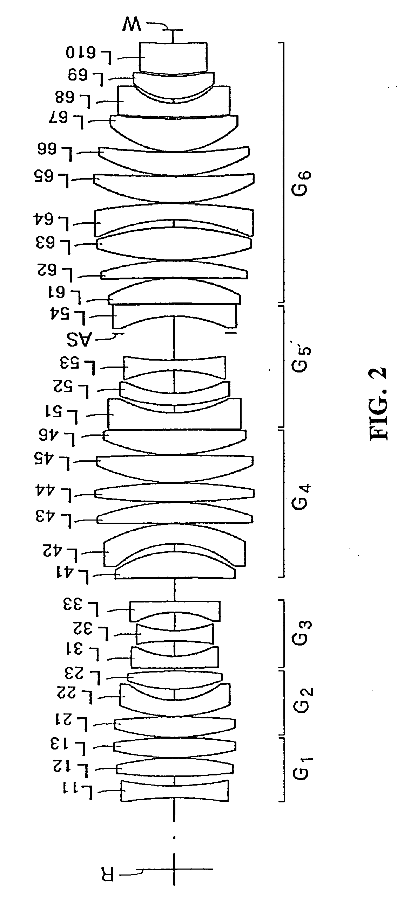

Described below are five example embodiments of a projection lens according to the present invention. The optical configurations of Example Embodiments 1-5 are depicted in FIGS. 2-6, respectively. In each example embodiment, the subject projection lens comprises, in order from the reticle R (serving as the "first object"), a first lens group $G_1$ having positive refractive power, a second lens group $G_2$ having positive refractive power, a third lens group $G_3$ having negative refractive power, a fourth lens group $G_4$ having positive refractive power, a fifth lens group $G_5$ having negative refractive power, and a sixth lens group $G_6$ having positive refractive power. The projection lens of each example embodiment is substantially telecentric on both the object side (i.e., the reticle side) and the image side (i.e., the wafer side), and exhibits a magnification of less than unity. Thus, each projection lens is a reducing lens.

The lens of each example embodiment has a numerical aperture NA on the image side of 0.6 and a projection magnification ($\beta$) of 1/4. The diameter of the exposure region on the wafer W in the first and second example embodiments is 26.8 mm; and the diameter of the exposure region on the wafer W in the third, fourth, and fifth example embodiments is 30.6 mm.

In the following descriptions of the example embodiments, lenses are introduced in order from the object side, unless indicated otherwise. The "object side" of a lens is the reticle (or "first-object") side; and the "image side" is the wafer (or "second-object") side. In each of FIGS. 2-6, the reticle is denoted by "R" and the wafer is denoted by "W". The optical axis of the projection lens extends between the reticle R and the wafer W.

In the first example embodiment shown in FIG. 2, the first lens group $G_1$ is configured as a "reversed telescopic system" and comprises a biconcave lens $L_{11}$ and two biconvex lenses $L_{12}$, $L_{13}$. By making $L_{11}$ biconcave, each surface thereof has a negative power to control generation of negative distortion and to contribute favorably to a low Petzval's sum for the projection lens.

The second lens group $G_2$ comprises a biconvex lens $L_{21}$, a negative meniscus lens $L_{22}$ having a concave surface facing toward the image side, and a biconvex lens $L_{23}$. The second lens group $G_2$ is configured so as to effectively correct distortion caused by passage of light through upstream convex lenses. The second lens group $G_2$ satisfies conditional expression (7) by having the concave surface of the meniscus lens $L_{22}$ facing toward the image side. Thus, contributions by the second lens group $G_2$ to a low Petzval's sum of the projection lens are appropriately controlled.

The third lens group $G_3$ comprises a negative meniscus lens $L_{31}$ having a concave surface facing the image side, a biconcave lens $L_{32}$, and a planoconcave lens $L_{33}$ having a concave surface facing the object side. Thus, the third lens group $G_3$ comprises four surfaces having a negative power useful for achieving a desired low Petzval's sum. The four negative-power surfaces are also useful for ensuring that coma aberrations are controlled to a degree allowing correction by other lens groups in the projection lens.

The fourth lens group $G_4$ comprises a positive meniscus lens $L_{41}$ having a convex surface facing toward the image side and a concave surface facing toward the object side, a negative meniscus lens $L_{42}$ with a concave surface facing toward the object side, and a series of four biconvex lenses $L_{43}$, $L_{44}$, $L_{45}$, $L_{46}$. The concave surface of the meniscus lens $L_{42}$ facing toward the object side limits increases to the Petzval's sum in a manner similar to the function of the lens $L_{22}$ of the second lens group $G_2$. Thus, the burden of the third lens group $G_3$ and the fifth lens group $G_5$ toward achieving a desired low Petzval's sum is reduced. This also helps prevent generation of excessive sagittal coma flare.

The fifth lens group $G_5$ comprises four concave lenses including a planoconcave lens $L_{51}$ having a concave surface facing toward the image side, a negative meniscus lens $L_{52}$ having a concave surface facing toward the image side, a biconcave lens $L_{53}$, and a negative meniscus lens $L_{54}$ having a concave surface facing toward the object side. In the first example embodiment, the aperture stop AS is disposed between the lenses $L_{53}$ and $L_{54}$ of the fifth lens group $G_5$. The concave surface of the concave lens $L_{51}$ facing toward the image side and the concave surface of the concave lens $L_{54}$ facing toward the object side are arranged symmetrically with respect to each other about the aperture stop AS in the manner of a double Gauss lens. These concave surfaces control generation of astigmatic aberrations. Because the lenses $L_{51}$, $L_{54}$ alone can exhibit the sagittal coma flare characteristic of a double Gauss lens, the two concave lenses $L_{52}$, $L_{53}$ are inserted between the opposing concave surfaces of the concave lenses $L_{51}$ and $L_{54}$ in the first example embodiment. In the fifth lens group $G_5$, the negative powers assigned to the concave surfaces control the generation of sagittal coma aberrations and favorably contribute to a low Petzval's sum to ensure the flatness of the image surface.

The sixth lens group $G_6$ comprises ten lenses, including two positive meniscus lenses $L_{61}$, $L_{62}$ each having a convex surface facing toward the image side, a biconvex lens $L_{63}$, a negative meniscus lens $L_{64}$ having concave surface facing toward the object side, three positive meniscus lenses $L_{65}$, $L_{66}$, $L_{67}$ each having a convex surface facing toward the object side, a negative meniscus lens $L_{68}$ having a concave surface facing toward the image side, and two positive meniscus lenses $L_{69}$, $L_{610}$ each having a convex surface facing toward the object side. By arranging the concave lens $L_{64}$ at a location where the light beam is greatly spread, and by providing this lens with a meniscus shape having a concave surface facing toward the object side, spherical aberrations are efficiently corrected.

Further with respect to the positive lenses of the sixth lens group, positive refractive power is contributed by a number of the lens surfaces in order to make as small as possible the generation of higher-order spherical aberrations or coma aberrations for a light beam with a numerical aperture NA of 0.6. In this example embodiment, although the power of the sixth lens group $G_6$ is produced by eight positive lenses and two negative lenses, the sixth lens group $G_6$ has at least six positive lenses which is preferable for correcting spherical aberrations. Also, by having the concave surface of the negative lens $L_{68}$ facing toward the image side, it is possible to achieve a favorable balance between correction of distortion and correction of coma aberrations.

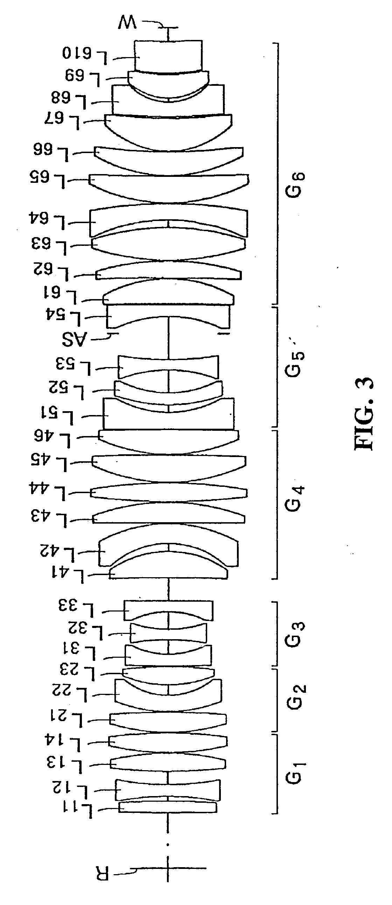

A projection lens according to the second example embodiment is shown in FIG. 3. The second example embodiment shares many similarities with the first embodiment, with one significant difference: the first lens group $G_1$ of the second example embodiment comprises four lenses rather than three. The first lens group $G_1$ of the second example embodiment comprises a biconvex lens $L_{11}$, a biconcave lens $L_{12}$, and two biconvex lenses $L_{13}$, $L_{14}$. Such a configuration contributes to achieving a favorable balance between correction of higher-order distortion and telecentricity extending across the entire exposure region while maintaining desirable contributions to a low Petzval's sum by the biconvex lens $L_{11}$ and the biconcave lens $L_{12}$.

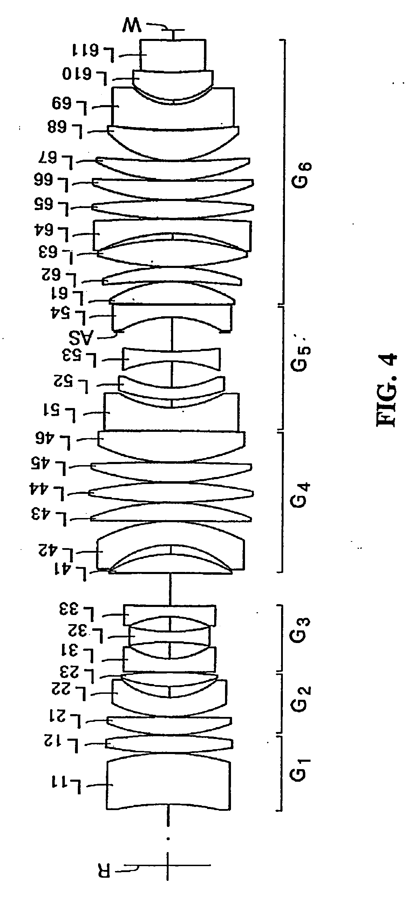

A projection lens according to the third example embodiment is shown in FIG. 4. The third example embodiment shares many similarities with the first example embodiment. But, there are differences. For example, the first lens group $G_1$ of the third example embodiment comprises only two lenses: a positive meniscus lens $L_{11}$ having a convex surface facing toward the image side, and a biconvex lens $L_{12}$. A group having such a configuration is termed "reversed telescopic" and does not require a negative lens in the first lens group $G_1$. By utilizing the somewhat thick positive meniscus lens $L_{11}$ having a concave surface facing toward the object side, conditional expression (3) can be satisfied. As a result, a desirably low Petzval's sum can be obtained for the projection lens.

Also with respect to the third example embodiment, four (rather than three as in the first example embodiment) convex lenses $L_{65}$, $L_{66}$, $L_{67}$, $L_{68}$ are disposed between the negative meniscus lens $L_{64}$ (having a concave surface facing toward the object side) and the negative meniscus lens $L_{69}$ (having a concave surface facing toward the image side). In the first example embodiment, three convex lenses $L_{65}$, $L_{66}$, $L_{67}$ were disposed in this region of the projection lens. In order to favorably correct spherical aberrations and coma aberrations, it is preferable to provide at least three convex lenses in this portion. In the third embodiment, spherical aberrations and coma aberrations are corrected even more favorably by these four convex lenses.

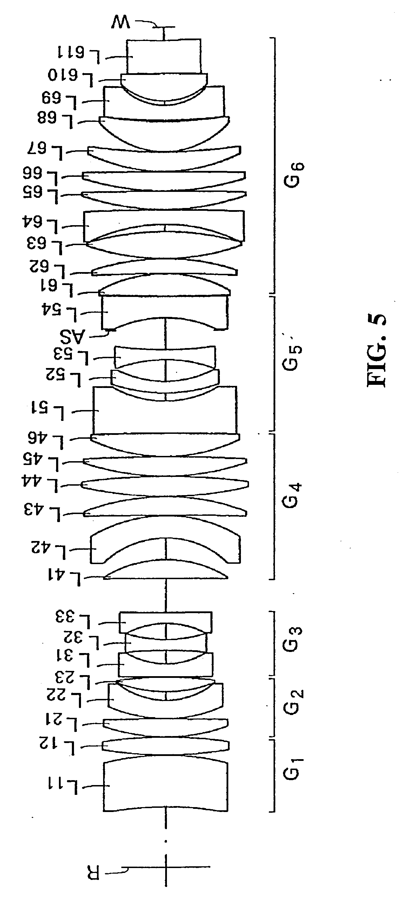

A projection lens according to the fourth example embodiment is shown in FIG. 5. The fourth example embodiment shares many similarities to the third example embodiment. The main point of distinction pertains to the axial distance, in the fourth example embodiment, between the lenses $L_{41}$ and $L_{42}$ of the fourth lens group $G_4$. The influence of this gap between the lenses $L_{41}$ and $L_{42}$ results in a balance of corrections of higher-order aberrations that is slightly different in the fourth example embodiment from the other example embodiments but achieves an overall performance that is almost identical to the other example embodiments.

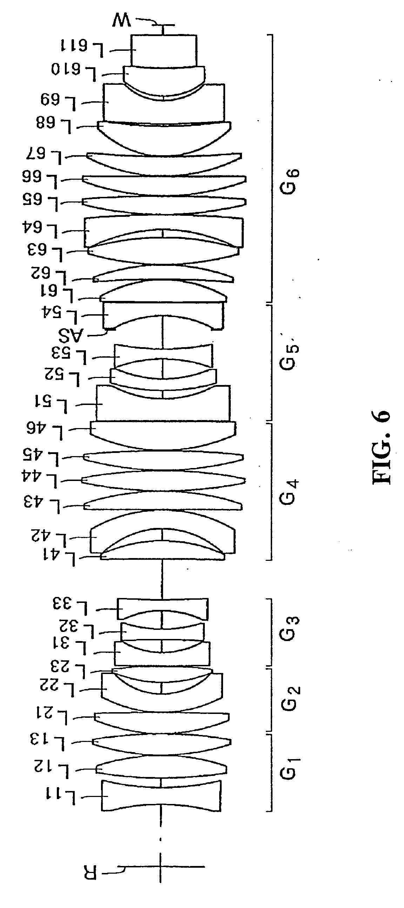

A projection lens according to the fifth example embodiment is shown in FIG. 6. The fifth example embodiment resembles the third example embodiment except that, in the fifth example embodiment, the first lens group $G_1$ comprises three lenses: a biconcave lens $L_{11}$ and two biconvex lenses $L_{12}$, $L_{13}$. By configuring the first lens group $G_1$ in the fifth example embodiment in such a manner with three lenses including the negative lens $L_{11}$, the Petzval's sum of the projection lens is even better.

In the fifth example embodiment, four positive lenses $L_{65}$, $L_{66}$, $L_{67}$, $L_{68}$ are disposed between the negative lenses $L_{64}$ and $L_{69}$ in the sixth lens group $G_6$ in a manner similar to the third example embodiment. As a result, coma aberrations can be corrected even for a wide angle of view, and a balance is achieved in the corrections of field curvature, spherical aberrations, and coma aberrations.

In Tables 1-5, below, provide physical data for each of example embodiments 1-5, respectively. In the tables, the first column lists the surface numbers from the object side (reticle side); the second column (labeled "r") lists the respective curvature radius of each lens surface; the third column (labeled "d") lists the axial distance between adjacent surfaces; the fourth column lists the respective lens material; and the fifth column lists the corresponding lens-group number for the lenses. The refractive indices $n$ of fused silica ($SiO_2$) and calcium fluoride ($CaF_2$) for an exposure wavelength of 193.4 nm are as follows:

$SiO_2$:     $n = 1.56019$

$CaF_2$:    $n = 1.50138$

In Table 6 below, numerical values for the various conditional expressions are listed for example embodiments 1-5. In Table 6, the symbol $\Sigma$ in the (7) row represents the expression $(\Sigma P_1 + \Sigma P_2)/\Sigma P_3$ of conditional expression (7). The letter S in row (9) denotes the number of the lens surface having the maximum power $\phi$ from among the third lens group $G_3$ and the fifth lens group $G_5$; $r_{min}$ is the curvature radius of that lens surface; $n$ is the refractive index of the lens having that surface; and $|\phi \cdot L|$ pertains to that lens surface. So long as conditional expression (9) is satisfied for a lens surface having a maximum power $\phi$, the other lens surfaces in the third lens group $G_3$ and the fifth lens group $G_5$ naturally satisfy conditional expression (9).

**Table 1**

(Example Embodiment 1)

| Surf. | r | d | Mat'l | Group |
|---|---|---|---|---|
| 0 | reticle | 103.390978 | | |
| 1 | -453.18731 | 17.000000 | $SiO_2$ | $G_1$ |
| 2 | 370.52697 | 13.613089 | | |
| 3 | 710.84358 | 26.000000 | $SiO_2$ | $G_1$ |
| 4 | -350.78200 | 1.000000 | | |
| 5 | 367.53957 | 28.000000 | $SiO_2$ | $G_1$ |
| 6 | -567.47540 | 1.000000 | | |
| 7 | 289.50734 | 29.000000 | $SiO_2$ | $G_2$ |
| 8 | -899.09021 | 1.000000 | | |
| 9 | 199.45895 | 23.000000 | $SiO_2$ | $G_2$ |
| 10 | 103.61200 | 15.764153 | | |
| 11 | 188.56105 | 25.800000 | $SiO_2$ | $G_2$ |
| 12 | -574.20881 | 4.242446 | | |
| 13 | 3000.00000 | 16.616840 | $SiO_2$ | $G_3$ |
| 14 | 118.18165 | 21.762847 | | |
| 15 | -336.11504 | 15.000000 | $SiO_2$ | $G_3$ |
| 16 | 161.39927 | 25.871656 | | |
| 17 | -120.57109 | 15.000000 | $SiO_2$ | $G_3$ |
| 18 | ∞ | 33.995810 | | |
| 19 | -2985.44349 | 36.979230 | $SiO_2$ | $G_4$ |
| 20 | -150.10550 | 11.683590 | | |
| 21 | -122.25791 | 28.000000 | $SiO_2$ | $G_4$ |

| Surf. | r | d | Mat'l | Group |
|---|---|---|---|---|
| 22 | -204.99200 | 1.000000 | | |
| 23 | ∞ | 29.240000 | $SiO_2$ | $G_4$ |
| 24 | -312.57215 | 1.000000 | | |
| 25 | 965.45342 | 27.000000 | $SiO_2$ | $G_4$ |
| 26 | -643.40298 | 1.000000 | | |
| 27 | 258.67450 | 39.000000 | $CaF_2$ | $G_4$ |
| 28 | -2967.14698 | 1.000000 | | |
| 29 | 246.35328 | 35.600000 | $CaF_2$ | $G_4$ |
| 30 | -2970.04481 | 1.000000 | | |
| 31 | ∞ | 24.000000 | $SiO_2$ | $G_5$ |
| 32 | 157.63171 | 10.667015 | | |
| 33 | 234.15227 | 17.000000 | $SiO_2$ | $G_5$ |
| 34 | 157.66180 | 32.592494 | | |
| 35 | -200.72428 | 15.000000 | $SiO_2$ | $G_5$ |
| 36 | 432.89447 | 37.939196 | | |
| 37 | Aperture stop | 24.400000 | | |
| 38 | -175.71116 | 17.000000 | $SiO_2$ | $G_5$ |
| 39 | -2985.98357 | 1.000000 | | |
| 40 | -2985.99700 | 35.500000 | $CaF_2$ | $G_6$ |
| 41 | -189.63629 | 1.000000 | | |
| 42 | -3000.00000 | 24.400000 | $SiO_2$ | $G_6$ |
| 43 | -350.29744 | 1.000000 | | |
| 44 | 362.38815 | 46.500000 | $CaF_2$ | $G_6$ |
| 45 | -361.31567 | 10.870000 | | |

| Surf. | r | d | Mat'l | Group |
|---|---|---|---|---|
| 46 | -251.97148 | 23.000000 | $SiO_2$ | $G_6$ |
| 47 | -662.28158 | 1.000000 | | |
| 48 | 238.98700 | 38.100000 | $CaF_2$ | $G_6$ |
| 49 | 1994.63265 | 1.000000 | | |
| 50 | 211.51173 | 33.400000 | $CaF_2$ | $G_6$ |
| 51 | 720.00000 | 1.000000 | | |
| 52 | 129.92966 | 46.000000 | $CaF_2$ | $G_6$ |
| 53 | 669.85166 | 2.783304 | | |
| 54 | 970.74182 | 19.986222 | $SiO_2$ | $G_6$ |
| 55 | 78.20244 | 6.273142 | | |
| 56 | 86.12755 | 32.522737 | $SiO_2$ | $G_6$ |
| 57 | 230.00000 | 2.862480 | | |
| 58 | 232.22064 | 44.183443 | $SiO_2$ | $G_6$ |
| 59 | 350.03691 | 19.466219 | | |
| 60 | Wafer | | | |

## Table 2

### (Example Embodiment 2)

| Surf. | r | d | Mat'l | Group |
|---|---|---|---|---|
| 0 | Reticle | 80.005623 | | |
| 1 | 3000.00000 | 17.000000 | $SiO_2$ | $G_1$ |
| 2 | -1100.07662 | 7.000000 | | |
| 3 | -382.34142 | 17.000000 | $SiO_2$ | $G_1$ |
| 4 | 370.98157 | 19.096933 | | |

11

| Surf. | r | d | Mat'l | Group |
|---|---|---|---|---|
| 5 | 741.43231 | 26.000000 | $SiO_2$ | $G_1$ |
| 6 | -346.96815 | 1.000000 | | |
| 7 | 378.55115 | 28.000000 | $SiO_2$ | $G_1$ |
| 8 | -618.11456 | 1.000000 | | |
| 9 | 291.02156 | 29.000000 | $SiO_2$ | $G_2$ |
| 10 | -960.02967 | 1.000000 | | |
| 11 | 213.50227 | 23.000000 | $SiO_2$ | $G_2$ |
| 12 | 102.07483 | 15.012850 | | |
| 13 | 181.74774 | 25.800000 | $SiO_2$ | $G_2$ |
| 14 | -533.56895 | 1.000000 | | |
| 15 | 2712.39289 | 16.616840 | $SiO_2$ | $G_3$ |
| 16 | 121.06433 | 20.547736 | | |
| 17 | -296.23495 | 15.000000 | $SiO_2$ | $G_3$ |
| 18 | 161.25942 | 25.185487 | | |
| 19 | -118.38102 | 15.000000 | $SiO_2$ | $G_3$ |
| 20 | $\infty$ | 33.572517 | | |
| 21 | -2884.98321 | 36.979230 | $SiO_2$ | $G_3$ |
| 22 | -146.43548 | 11.683590 | | |
| 23 | -120.69431 | 28.000000 | $SiO_2$ | $G_4$ |
| 24 | -204.17381 | 1.000000 | | |
| 25 | $\infty$ | 29.240000 | $SiO_2$ | $G_4$ |
| 26 | -312.30286 | 1.000000 | | |
| 27 | 903.22838 | 27.000000 | $SiO_2$ | $G_4$ |
| 28 | -665.97951 | 1.000000 | | |
| 29 | 260.25775 | 39.000000 | $CaF_2$ | $G_4$ |

| Surf. | r | d | Mat'l | Group |
|---|---|---|---|---|
| 30 | -2965.88489 | 1.000000 | | |
| 31 | 239.96625 | 35.600000 | $CaF_2$ | $G_4$ |
| 32 | -3000.00000 | 1.000000 | | |
| 33 | $\infty$ | 24.000000 | $SiO_2$ | $G_5$ |
| 34 | 153.46592 | 10.823731 | | |
| 35 | 231.12502 | 17.000000 | $SiO_2$ | $G_5$ |
| 36 | 157.10450 | 32.398005 | | |
| 37 | -195.18116 | 15.000000 | $SiO_2$ | $G_5$ |
| 38 | 443.35877 | 37.069128 | | |
| 39 | Aperture Stop | 24.400000 | | |
| 40 | -175.99683 | 17.000000 | $SiO_2$ | $G_5$ |
| 41 | -2899.97402 | 1.000000 | | |
| 42 | -2966.55706 | 35.500000 | $CaF_2$ | $G_6$ |
| 43 | -188.48712 | 1.000000 | | |
| 44 | -3000.00000 | 24.400000 | $SiO_2$ | $G_6$ |
| 45 | -353.86205 | 1.000000 | | |
| 46 | 361.05640 | 46.500000 | $CaF_2$ | $G_6$ |
| 47 | -362.74962 | 10.870000 | | |
| 48 | -252.13935 | 23.000000 | $SiO_2$ | $G_6$ |
| 49 | -639.45695 | 1.000000 | | |
| 50 | 247.94411 | 38.100000 | $CaF_2$ | $G_6$ |
| 51 | 2772.28294 | 1.000000 | | |
| 52 | 215.80752 | 33.400000 | $CaF_2$ | $G_6$ |
| 53 | 741.95006 | 1.000000 | | |

| Surf. | r | d | Mat'l | Group |
|-------|------|------|-------|-------|
| 54 | 129.48833 | 46.000000 | $CaF_2$ | $G_6$ |
| 55 | 603.00127 | 2.812610 | | |
| 56 | 838.71234 | 21.000000 | $SiO_2$ | $G_6$ |
| 57 | 78.85022 | 5.688924 | | |
| 58 | 86.96257 | 33.318579 | $SiO_2$ | $G_6$ |
| 59 | 230.00000 | 1.975770 | | |
| 60 | 232.95189 | 44.943637 | $SiO_2$ | $G_6$ |
| 61 | 350.55917 | 19.466219 | | |
| 62 | Wafer | | | |

## Table 3

### (Example Embodiment 3)

| Surf. | r | d | Mat'l | Group |
|-------|------|------|-------|-------|
| 0 | reticle | 87.842324 | | |
| 1 | -351.29858 | 74.258738 | $SiO_2$ | $G_1$ |
| 2 | -298.15798 | 0.500000 | | |
| 3 | 553.95876 | 25.000000 | $SiO_2$ | $G_1$ |
| 4 | -617.71850 | 0.500000 | | |
| 5 | 253.09163 | 25.500000 | $SiO_2$ | $G_2$ |
| 6 | -3777.33056 | 0.500000 | | |
| 7 | 190.14717 | 27.805896 | $SiO_2$ | $G_2$ |
| 8 | 105.42692 | 15.912587 | | |
| 9 | 201.82417 | 20.000000 | $SiO_2$ | $G_2$ |
| 10 | -584.55642 | 0.500000 | | |

| Surf. | r | d | Mat'l | Group |
|---|---|---|---|---|
| 11 | 3000.00000 | 19.095104 | $SiO_2$ | $G_3$ |
| 12 | 105.34607 | 23.338460 | | |
| 13 | -337.23699 | 15.382167 | $SiO_2$ | $G_3$ |
| 14 | 248.69492 | 21.216782 | | |
| 15 | -133.88017 | 15.448042 | $SiO_2$ | $G_3$ |
| 16 | 2973.13758 | 47.591478 | | |
| 17 | -5000.00000 | 26.416153 | $SiO_2$ | $G_4$ |
| 18 | -169.85758 | 13.500000 | | |
| 19 | -125.21057 | 33.670949 | $SiO_2$ | $G_4$ |
| 20 | -220.03085 | 0.500000 | | |
| 21 | ∞ | 26.520978 | $SiO_2$ | $G_4$ |
| 22 | -325.33259 | 0.500000 | | |
| 23 | 736.93850 | 29.000000 | $SiO_2$ | $G_4$ |
| 24 | -560.64661 | 0.500000 | | |
| 25 | 366.01277 | 28.000000 | $SiO_2$ | $G_4$ |
| 26 | -3481.04946 | 0.500000 | | |
| 27 | 242.17825 | 45.121070 | $CaF_2$ | $G_4$ |
| 28 | -5000.00000 | 0.500000 | | |
| 29 | ∞ | 34.715089 | $SiO_2$ | $G_5$ |
| 30 | 152.12354 | 11.669230 | | |
| 31 | 237.82697 | 16.443006 | $SiO_2$ | $G_5$ |
| 32 | 154.91919 | 38.109146 | | |
| 33 | -185.64902 | 14.321328 | $SiO_2$ | $G_5$ |
| 34 | 559.07808 | 26.892063 | | |

| Surf. | r | d | Mat'l | Group |
|---|---|---|---|---|
| 35 | Aperture stop | 21.952360 | | |
| 36 | -147.25357 | 17.830696 | $SiO_2$ | $G_5$ |
| 37 | ∞ | 0.500000 | | |
| 38 | 5000.00000 | 32.000000 | $CaF_2$ | $G_6$ |
| 39 | -170.72868 | 0.500000 | | |
| 40 | -930.41140 | 21.00000 | $SiO_2$ | $G_6$ |
| 41 | -289.67853 | 0.500000 | | |
| 42 | 403.38962 | 38.720628 | $CaF_2$ | $G_6$ |
| 43 | -327.35127 | 9.017132 | | |
| 44 | -229.80012 | 21.000000 | $SiO_2$ | $G_6$ |
| 45 | -1820.23082 | 0.500000 | | |
| 46 | 535.39152 | 26.000000 | $CaF_2$ | $G_6$ |
| 47 | -988.48090 | 0.500000 | | |
| 48 | 327.47057 | 27.500000 | $SiO_2$ | $G_6$ |
| 49 | 4987.19075 | 0.500000 | | |
| 50 | 253.24680 | 27.500000 | $CaF_2$ | $G_6$ |
| 51 | 1316.11991 | 0.500000 | | |
| 52 | 132.63747 | 42.963984 | $CaF_2$ | $G_6$ |
| 53 | 629.46057 | 1.800000 | | |
| 54 | 868.98502 | 35.719214 | $SiO_2$ | $G_6$ |
| 55 | 80.85953 | 6.365035 | | |
| 56 | 88.09767 | 39.251047 | $CaF_2$ | $G_6$ |
| 57 | 355.00000 | 0.530420 | | |
| 58 | 351.07133 | 45.922298 | $SiO_2$ | $G_6$ |

| Surf. | r | d | Mat'l | Group |
|---|---|---|---|---|
| 59 | 436.07534 | 14.155299 | | |
| 60 | Wafer | | | |

**Table 4**

(Example Embodiment 4)

| Surf. | r | d | Mat'l | Group |
|---|---|---|---|---|
| 0 | reticle | 86.313742 | | |
| 1 | -433.57842 | 74.258738 | $SiO_2$ | $G_1$ |
| 2 | -331.50654 | 0.500000 | | |
| 3 | 559.96288 | 25.000000 | $SiO_2$ | $G_1$ |
| 4 | -583.13377 | 0.50000 | | |
| 5 | 262.88205 | 25.50000 | $SiO_2$ | $G_2$ |
| 6 | -2712.40287 | 0.50000 | | |
| 7 | 193.77173 | 26.000000 | $SiO_2$ | $G_2$ |
| 8 | 107.21122 | 12.619545 | | |
| 9 | 190.85163 | 20.000000 | $SiO_2$ | $G_2$ |
| 10 | -560.78221 | 0.500000 | | |
| 11 | 4482.98861 | 19.095104 | $SiO_2$ | $G_3$ |
| 12 | 109.25270 | 19.036007 | | |
| 13 | -562.52015 | 15.382167 | $SiO_2$ | $G_3$ |
| 14 | 184.00884 | 23.167680 | | |
| 15 | -117.90615 | 15.448042 | $SiO_2$ | $G_3$ |
| 16 | 5000.00000 | 48.718404 | | |
| 17 | -5000.00000 | 26.416153 | $SiO_2$ | $G_4$ |

17

| Surf. | r | d | Mat'l | Group |
|---|---|---|---|---|
| 18 | -165.73836 | 31.081545 | | |
| 19 | -124.20414 | 31.565534 | $SiO_2$ | $G_4$ |
| 20 | -203.09274 | 0.500000 | | |
| 21 | -4915.52505 | 26.520978 | $SiO_2$ | $G_4$ |
| 22 | -321.56546 | 0.500000 | | |
| 23 | 509.82729 | 29.000000 | $SiO_2$ | $G_4$ |
| 24 | -906.29678 | 0.500000 | | |
| 25 | 360.83202 | 28.000000 | $SiO_2$ | $G_4$ |
| 26 | -2069.90140 | 0.500000 | | |
| 27 | 246.84282 | 32.884285 | $CaF_2$ | $G_4$ |
| 28 | -3200.00000 | 0.500000 | | |
| 29 | -4980.80583 | 46.093480 | $SiO_2$ | $G_5$ |
| 30 | 148.03902 | 11.669230 | | |
| 31 | 234.61256 | 16.443006 | $SiO_2$ | $G_5$ |
| 32 | 153.45418 | 31.004339 | | |
| 33 | -188.95798 | 14.321328 | $SiO_2$ | $G_5$ |
| 34 | 500.84049 | 26.892063 | | |
| 35 | Aperture Stop | 18.228745 | | |
| 36 | -167.99189 | 30.216688 | $SiO_2$ | $G_5$ |
| 37 | 5000.00000 | 0.500000 | | |
| 38 | 3130.64989 | 32.000000 | $CaF_2$ | $G_6$ |
| 39 | -188.11418 | 0.500000 | | |
| 40 | -1898.83868 | 21.000000 | $SiO_2$ | $G_6$ |
| 41 | -330.33425 | 0.500000 | | |

| Surf. | r | d | Mat'l | Group |
|-------|-----------|-----------|---------|-------|
| 42 | 336.89888 | 38.720628 | $CaF_2$ | $G_6$ |
| 43 | -378.84873 | 9.985852 | | |
| 44 | -244.09971 | 21.000000 | $SiO_2$ | $G_6$ |
| 45 | -2680.44816 | 0.500000 | | |
| 46 | 359.48999 | 26.00000 | $CaF_2$ | $G_6$ |
| 47 | -5000.00000 | 0.500000 | | |
| 48 | 391.78229 | 27.500000 | $SiO_2$ | $G_6$ |
| 49 | -5000.00000 | 0.500000 | | |
| 50 | 248.57500 | 27.500000 | $CaF_2$ | $G_6$ |
| 51 | 723.23935 | 0.500000 | | |
| 52 | 123.06548 | 42.963984 | $CaF_2$ | $G_6$ |
| 53 | 568.02920 | 1.929341 | | |
| 54 | 798.40481 | 21.145491 | $SiO_2$ | $G_6$ |
| 55 | 80.88243 | 6.365035 | | |
| 56 | 89.63627 | 39.251047 | $CaF_2$ | $G_6$ |
| 57 | -3000.00000 | 0.530420 | | |
| 58 | -4944.71373 | 46.500000 | $SiO_2$ | $G_6$ |
| 59 | 442.15484 | 18.732427 | | |
| 60 | Wafer | | | |

## Table 5

### (Example Embodiment 5)

| Surf. | r | d | Mat'l | Group |
|---|---|---|---|---|
| 0 | reticle | 89.938439 | | |
| 1 | -278.31968 | 24.324989 | $SiO_2$ | $G_1$ |
| 2 | 358.97399 | 14.000000 | | |
| 3 | 630.65888 | 32.000000 | $SiO_2$ | $G_1$ |
| 4 | -279.63900 | 0.500000 | | |
| 5 | 324.80109 | 30.000000 | $SiO_2$ | $G_1$ |
| 6 | -569.64601 | 0.500000 | | |
| 7 | 254.51115 | 30.000000 | $SiO_2$ | $G_2$ |
| 8 | -2773.53473 | 0.500000 | | |
| 9 | 188.08534 | 26.000000 | $SiO_2$ | $G_2$ |
| 10 | 98.24738 | 16.726944 | | |
| 11 | 192.49488 | 23.000000 | $SiO_2$ | $G_2$ |
| 12 | -556.35255 | 0.500000 | | |
| 13 | 4619.33310 | 19.095104 | $SiO_2$ | $G_3$ |
| 14 | 116.41300 | 18.338460 | | |
| 15 | -1099.49346 | 15.382167 | $SiO_2$ | $G_3$ |
| 16 | 190.51069 | 26.216782 | | |
| 17 | -132.37738 | 15.448042 | $SiO_2$ | $G_3$ |
| 18 | 1189.93256 | 57.729814 | | |
| 19 | -5000.00000 | 26.416153 | $SiO_2$ | $G_4$ |
| 20 | -203.62120 | 17.048271 | | |
| 21 | -123.56550 | 26.327345 | $SiO_2$ | $G_4$ |

| Surf. | r | d | Mat'l | Group |
|---|---|---|---|---|
| 22 | -204.21523 | 0.500000 | | |
| 23 | ∞ | 26.520978 | $SiO_2$ | $G_4$ |
| 24 | -345.79464 | 0.500000 | | |
| 25 | 584.04620 | 29.000000 | $SiO_2$ | $G_4$ |
| 26 | -602.24304 | 0.500000 | | |
| 27 | 421.56019 | 28.000000 | $SiO_2$ | $G_4$ |
| 28 | -1123.34423 | 0.500000 | | |
| 29 | 246.29006 | 41.457735 | $CaF_2$ | $G_4$ |
| 30 | -5000.00000 | 0.500000 | | |
| 31 | ∞ | 31.780371 | $SiO_2$ | $G_5$ |
| 32 | 159.19296 | 11.669230 | | |
| 33 | 281.83842 | 16.443006 | $SiO_2$ | $G_5$ |
| 34 | 175.89651 | 28.590762 | | |
| 35 | -193.86521 | 14.321328 | $SiO_2$ | $G_5$ |
| 36 | 373.19656 | 26.892063 | | |
| 37 | Aperture stop | 20.226657 | | |
| 38 | -151.07311 | 18.537276 | $SiO_2$ | $G_5$ |
| 39 | ∞ | 0.500000 | | |
| 40 | 5000.00000 | 32.000000 | $CaF_2$ | $G_6$ |
| 41 | -182.33571 | 0.500000 | | |
| 42 | -1290.51915 | 21.000000 | $SiO_2$ | $G_6$ |
| 43 | -281.02753 | 0.500000 | | |
| 44 | 389.15318 | 38.720628 | $CaF_2$ | $G_6$ |
| 45 | -363.76526 | 10.923296 | | |

| Surf. | r | d | Mat'l | Group |
|---|---|---|---|---|
| 46 | -227.45443 | 21.000000 | $SiO_2$ | $G_6$ |
| 47 | -1226.77556 | 0.500000 | | |
| 48 | 490.61591 | 26.000000 | $CaF_2$ | $G_6$ |
| 49 | -1451.02767 | 0.500000 | | |
| 50 | 342.24280 | 27.500000 | $SiO_2$ | $G_6$ |
| 51 | ∞ | 0.500000 | | |
| 52 | 245.62492 | 27.500000 | $CaF_2$ | $G_6$ |
| 53 | 1282.50070 | 27.500000 | | |
| 54 | 134.57766 | 42.963984 | $CaF_2$ | $G_6$ |
| 55 | 635.87829 | 3.137255 | | |
| 56 | 951.66806 | 33.023520 | $SiO_2$ | $G_6$ |
| 57 | 83.44325 | 6.365035 | | |
| 58 | 91.79955 | 39.251047 | $CaF_2$ | $G_6$ |
| 59 | 355.00000 | 0.530420 | | |
| 60 | 341.48270 | 46.500000 | $SiO_2$ | $G_6$ |
| 61 | 465.17186 | 14.155299 | | |
| 62 | Wafer | | | |

Table 6

| Cond. Exp. | Variable | Embodiment Number | | | | |
|---|---|---|---|---|---|---|
| | | 1 | 2 | 3 | 4 | 5 |
| (1) | $E_n$ | 4040.2 | 4143.5 | 3221.0 | 3098.6 | 3315.9 |
| | L | 1200 | 1200 | 1200 | 1200 | 1200 |
| (2) | $E_x$ | -19785.5 | -21729.2 | -16530.8 | -16521.4 | -17323.4 |
| | $\beta$ | -0.25 | -0.25 | -0.25 | -0.25 | -0.25 |
| | $|L/\beta|$ | 4800 | 4800 | 4800 | 4800 | 4800 |
| (3) | $bf_1$ | 425.457 | 374.783 | 426.000 | 404.945 | 415.223 |
| | $f_1$ | 402.204 | 361.596 | 405.169 | 390.801 | 375.243 |
| | $bf_1/f_1$ | 1.058 | 1.036 | 1.051 | 1.036 | 1.107 |
| (4) | $f_3$ | -58.747 | -58.282 | -63.470 | -61.333 | -66.475 |
| | $|f_3/L|$ | 0.049 | 0.049 | 0.053 | 0.051 | 0.055 |
| (5) | $f_5$ | -64.565 | -63.925 | -58.541 | -60.395 | -60.039 |
| | $|f_5/L|$ | 0.054 | 0.053 | 0.049 | 0.050 | 0.050 |
| (6) | $f_4$ | 123.634 | 122.810 | 128.251 | 131.647 | 131.280 |
| | $f_6$ | 109.563 | 108.867 | 103.822 | 106.137 | 105.207 |
| | $f_6/f_4$ | 0.886 | 0.886 | 0.810 | 0.806 | 0.801 |
| (7) | $[\Sigma]$ | -0.422 | -0.431 | -0.442 | -0.453 | -0.357 |
| (8) | $f_2$ | 258.588 | 266.756 | 266.822 | 255.282 | 275.357 |
| | $f_2/L$ | 0.215 | 0.222 | 0.222 | 0.213 | 0.229 |
| (9) | S | 14 | 19 | 8 | 12 | 14 |
| | $r_{min}$ | 118.18165 | -118.38102 | 105.42692 | 109.25270 | 116.41300 |
| | n | 1.56019 | 1.56019 | 1.56019 | 1.56019 | 1.56019 |
| | $|\phi \cdot L|$ | 5.688 | 5.679 | 6.376 | 6.153 | 5.775 |

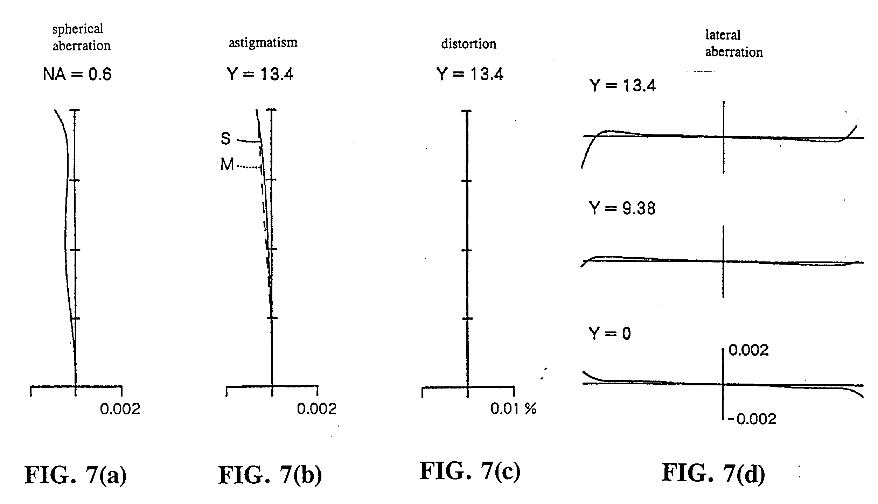

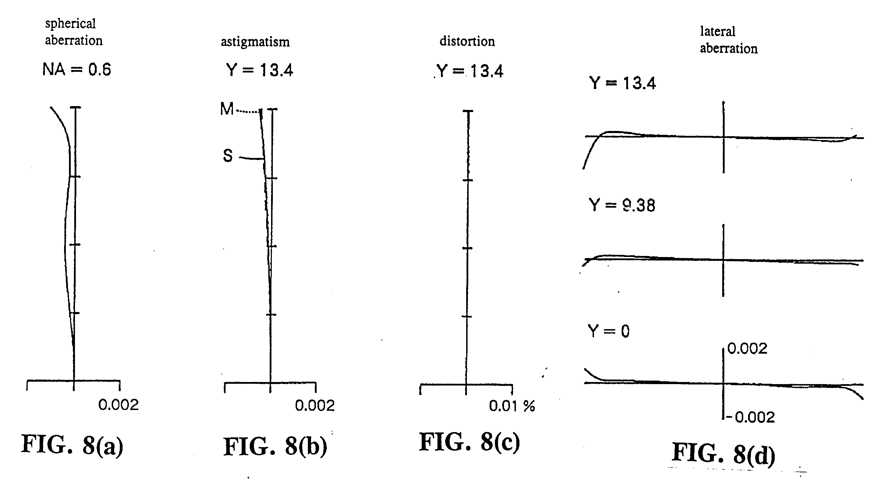

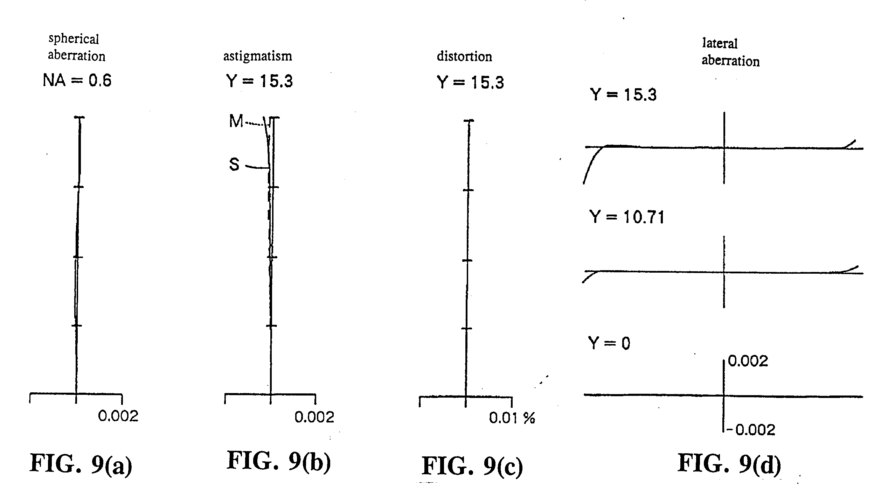

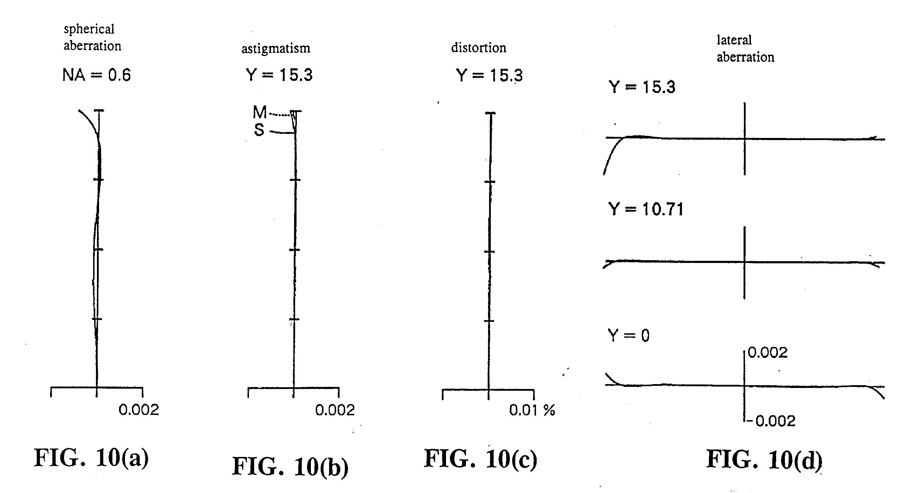

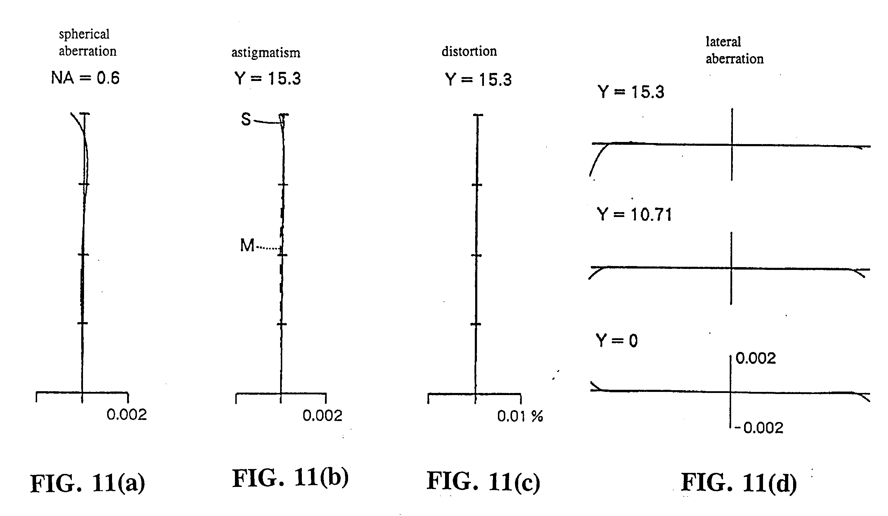

FIGS. 7(a)-7(d) provide plots of spherical aberration, astigmatism, distortion, and lateral aberrations, respectively, for Example Embodiment 1. FIGS. 8(a)-8(d), 9(a)-9(d), 10(a)-10(d), and 11(a)-11(d) provide similar plots for Example Embodiments 2-5, respectively. In each of FIGS. 7(b), 8(b), 9(b), 10(b), and 11(b), the dashed curve pertains to the meridional image surface and the solid line pertains to the sagittal image surface.

As can be clearly seen from the aberration plots, each of Example Embodiments 1-5 provides highly favorable imaging performance.

Although a projection-exposure apparatus according to the present invention preferably utilizes light from a 193.4-nm excimer laser for exposure, the invention is not limited to such a light source. Extreme ultraviolet light sources such as any of various other excimer lasers (e.g., KrF laser producing a light wavelength of 248.4 nm), high-pressure mercury arc lamps (generating, e.g., i-line light of 365 nm), or other suitable light sources generating light in the extreme ultraviolet region can be utilized.

The example embodiments comprised lens elements made from either of two types of optical materials to correct color aberrations while taking into account the spectrum width of the exposure wavelength. However, improvements in the technology for further narrowing the oscillation wavelength of an excimer laser could allow projection lenses according to this invention to be made of a single optical material, which would lower costs. Alternatively, a plurality of optical materials to correct color aberrations arising from use of light having an even wider spectrum can be used in the projection lenses to improve throughput.

Therefore, projection lenses according to this invention are telecentric on both sides and provide a high degree of balanced aberration correction and a high numerical aperture for high-resolution exposure. Specifically, distortion, coma, and Petzval's sum are favorably corrected to a fine degree.

Whereas the invention has been described in connection with a preferred embodiment and multiple example embodiments, it will be understood that the invention is not limited to those embodiments. On the contrary, the invention is intended to encompass all modifications, alternatives, and equivalents as may be included within the spirit and scope of the invention as defined by the appended claims.

**Claims**

1. A projection lens system for projecting an image of a first object R onto a second object W, the projection lens system comprising, in order from the first-object side:

(a) a first lens group $G_1$ having a positive power and a focal length $f_1$, a second lens group $G_2$ having a positive power and a focal length $f_2$, a third lens group $G_3$ having a negative power and a focal length $f_3$, a fourth lens group $G_4$ having a positive power and a focal length $f_4$, a fifth lens group $G_5$ having a negative power and a focal length $f_5$, and a sixth lens group $G_6$ having a positive power and a focal length $f_6$;
(b) the projection lens having an entrance pupil and an exit pupil, and exhibiting a projection magnification $\beta$; and
(c) the projection lens system satisfying conditional expressions as follows:

$$|E_n| > L$$

$$|E_x| > |L/\beta|$$

$$1.0 < bf_1/f_1 < 1.5$$

$$0.04 < |f_3/L| < 0.06$$

$$0.04 < |f_5/L| < 0.06$$

$$0.6 < f_6/f_4 < 1.3$$

wherein L is an axial distance from the first object to the second object; $E_n$ is a distance from an axial vertex of a most first-objectwise lens surface of the lens system to the entrance pupil; $E_x$ is a distance from an axial vertex of a most second-objectwise lens surface of the lens system to the exit pupil; and $bf_1$ is a distance from an axial vertex of a most second-objectwise lens surface of the first lens group to a rear focal point of the first lens group.

2. The projection lens system of claim 1, satisfying at least one of the following conditional expressions:

$$-0.5 < (\Sigma P_1 + \Sigma P_2)/\Sigma P_3 < -0.2$$

$$0.14 < f_2/L < 0.25$$

$$|\phi \cdot L| < 6.7$$

wherein $\Sigma P_1$ is a Petzval's sum of the first lens group $G_1$; $\Sigma P_2$ is a Petzval's sum of the second lens group $G_2$; $\Sigma P_3$ is a Petzval's sum of the third lens group $G_3$; and $\phi$ is a power of any lens surface in the third lens group $G_3$ and the fifth lens group $G_5$.

3. The projection lens system of claim 1, wherein the first lens group $G_1$ has a power configuration of a reversed telescopic system.

4. The projection lens system of claim 3, satisfying at least one of the following conditional expressions:

$$-0.5 < (\Sigma P_1 + \Sigma P_2)/\Sigma P_3 < -0.2$$

$$0.14 < f_2/L < 0.25$$

$$|\phi \cdot L| < 6.7$$

wherein $\Sigma P_1$ is a Petzval's sum of the first lens group $G_1$; $\Sigma P_2$ is a Petzval's sum of the second lens group $G_2$; $\Sigma P_3$ is a Petzval's sum of the third lens group $G_3$; and $\phi$ is a power of any lens surface in the third lens group $G_3$ and the fifth lens group $G_5$.

5. The projection lens system of claim 1, wherein $|\beta| < 1$.

6. The projection lens system of claim 5, satisfying at least one of the following conditional expressions:

$$-0.5 < (\Sigma P_1 + \Sigma P_2)/\Sigma P_3 < -0.2$$

$$0.14 < f_2/L < 0.25$$

$$|\phi \cdot L| < 6.7$$

wherein $\Sigma P_1$ is a Petzval's sum of the first lens group $G_1$; $\Sigma P_2$ is a Petzval's sum of the second lens group $G_2$; $\Sigma P_3$ is a Petzval's sum of the third lens group $G_3$; and $\phi$ is a power of any lens surface in the third lens group $G_3$ and the fifth lens group $G_5$.

7. The projection lens system of claim 1, wherein the sixth lens group $G_6$ comprises at least six lenses individually having a positive power.

8. The projection lens system of claim 7, satisfying at least one of the following conditional expressions:

$$-0.5 < (\Sigma P_1 + \Sigma P_2)/\Sigma P_3 < -0.2$$

$$0.14 < f_2/L < 0.25$$

$$|\phi \cdot L| < 6.7$$

wherein $\Sigma P_1$ is a Petzval's sum of the first lens group $G_1$; $\Sigma P_2$ is a Petzval's sum of the second lens group $G_2$; $\Sigma P_3$ is a Petzval's sum of the third lens group $G_3$; and $\phi$ is a power of any lens surface in the third lens group $G_3$ and the fifth lens group $G_5$.

9. A projection-exposure apparatus, comprising:

(a) an illumination-optical system for illuminating a reticle defining a pattern;
(b) a projection lens system for receiving illumination light passing through the reticle and for projecting an image of the reticle pattern onto a substrate, the projection lens comprising, in order from a reticle side to an substrate side:

(i) a first lens group $G_1$ having a positive power and a focal length $f_1$, a second lens group $G_2$ having a positive power and a focal length $f_2$, a third lens group $G_3$ having a negative power and a focal length $f_3$, a fourth lens group $G_4$ having a positive power and a focal length $f_4$, a fifth lens group $G_5$ having a negative power and a focal length $f_5$, and a sixth lens group $G_6$ having a positive power and a focal length $f_6$;
(ii) the projection lens having an entrance pupil and an exit pupil, and exhibiting a projection magnification $\beta$; and
(iii) the projection lens system satisfying conditional expressions as follows:

$$|E_n| > L$$

$$|E_x| > |L/\beta|$$

$$1.0 < bf_1/f_1 < 1.5$$

$$0.04 < |f_3/L| < 0.06$$

**EP 0 828 172 A1**

$$0.04 < |f_5/L| < 0.06$$

$$0.6 < f_6/f_4 < 1.3$$

wherein L is an axial distance from the reticle to the substrate; $E_n$ is a distance from an axial vertex of a most objectwise lens surface of the lens system to the entrance pupil; $E_x$ is a distance from an axial vertex of a most imagewise lens surface of the lens system to the exit pupil; and $bf_1$ is a distance from an axial vertex of a most imagewise lens surface of the first lens group $G_1$ to a rear focal point of the first lens group $G_1$.

**FIG. 1**

FIG. 2

FIG. 3

FIG. 4

**FIG. 5**

FIG. 6

FIG. 7(a)  FIG. 7(b)  FIG. 7(c)  FIG. 7(d)

spherical aberration — NA = 0.6 — 0.002

astigmatism — Y = 13.4 — S, M — 0.002

distortion — Y = 13.4 — 0.01 %

lateral aberration — Y = 13.4, Y = 9.38, Y = 0 — 0.002, −0.002

spherical
aberration

NA = 0.6

astigmatism

Y = 13.4

distortion

Y = 13.4

lateral
aberration

Y = 13.4

Y = 9.38

M

S

Y = 0

0.002

0.002

0.002

0.01 %

0.002

-0.002

**FIG. 8(a)**

**FIG. 8(b)**

**FIG. 8(c)**

**FIG. 8(d)**

EP 0 828 172 A1

35

spherical
aberration

NA = 0.6

0.002

**FIG. 9(a)**

astigmatism

Y = 15.3

M

S

0.002

**FIG. 9(b)**

distortion

Y = 15.3

0.01 %

**FIG. 9(c)**

lateral
aberration

Y = 15.3

Y = 10.71

Y = 0

0.002

-0.002

**FIG. 9(d)**

EP 0 828 172 A1

spherical
aberration

NA = 0.6

astigmatism

Y = 15.3

distortion

Y = 15.3

lateral
aberration

Y = 15.3

M
S

Y = 10.71

Y = 0

0.002

0.002

0.01 %

0.002

-0.002

**FIG. 10(a)**

**FIG. 10(b)**

**FIG. 10(c)**

**FIG. 10(d)**

36

EP 0 828 172 A1

spherical
aberration

NA = 0.6

astigmatism

Y = 15.3

distortion

Y = 15.3

lateral
aberration

Y = 15.3

S

M

Y = 10.71

Y = 0

0.002

0.002

0.002

0.01 %

-0.002

FIG. 11(a)

FIG. 11(b)

FIG. 11(c)

FIG. 11(d)

**European Patent Office**

## EUROPEAN SEARCH REPORT

Application Number

EP 97 11 4588

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>A | EP 0 717 299 A (NIPPON KOGAKU KK)<br>* page 8, line 50 - page 11, line 15; figure 7; tables 9,10 * | 1,5,9<br>2-4,6-8 | G02B13/24<br>G03F7/20 |
| A | EP 0 721 150 A (NIPPON KOGAKU KK)<br>* the whole document * | 1-9 | |

TECHNICAL FIELDS
SEARCHED        (Int.Cl.6)

G02B
G03F

The present search report has been drawn up for all claims

| Place of search | Date of completion of the search | Examiner |
|---|---|---|
| BERLIN | 9 December 1997 | von Moers, F |

EPO FORM 1503 03.82 (P04C01)